Europäisches Patentamt

European Patent Office

Office européen des brevets

(11) Publication number: 0 386 993 B1

# EUROPEAN PATENT SPECIFICATION

(45) Date of publication of patent specification: 08.11.95   (51) Int. Cl.⁶: C03C 17/36

(21) Application number: 90302355.4

(22) Date of filing: 06.03.90

(54) Heat treatable sputter-coated glass.

(30) Priority: 10.10.89 US 418959
09.03.89 US 321060

(43) Date of publication of application:
12.09.90 Bulletin 90/37

(45) Publication of the grant of the patent:
08.11.95 Bulletin 95/45

(84) Designated Contracting States:
DE ES FR GB IT LU

(56) References cited:
EP-A- 0 041 463        EP-A- 0 140 032
EP-A- 0 224 704        EP-A- 0 239 750
EP-A- 0 301 755        EP-A- 0 303 109
US-A- 3 826 728        US-A- 4 790 922

(73) Proprietor: GUARDIAN INDUSTRIES CORP.
43043 West Nine Mile Road
Northville
Michigan 48167 (US)

(72) Inventor: Lingle, Philip J.
4279 Little Streams Tr.
Lambertville,
Michigan 48144 (US)
Inventor: Nalepka, Raymond
1242 Selma
Westland,
Michigan 48185 (US)

(74) Representative: Hayward, Denis Edward Peter
et al
Lloyd Wise, Tregear & Co.
Norman House
105-109 Strand
London WC2R 0AE (GB)

**Description**

This invention relates to glasses provided with specific coatings which may thereafter be heat treated at temperatures sufficiently elevated to bend, heat-strengthen, and/or temper the glass. The invention finds particular utility in architectural and automotive glass production.

The popularity of metal or metal-oxide coated glasses in architectural and automotive design is well known. As reported prolifically in patent and other literature, such glasses thru the manipulation of the coating's layering system, usually by choice of metals and/or metal oxides and/or thicknesses, can usually achieve, quite acceptably, the degree of reflectance, transmittance, emissivity and durability, as well as the color, desired. See, for example, U. S. Patent Nos. 3,935,351; 4,413,877; 4,462,883; 3,826,728; 3,681,042; 3,798,146; and 4,594,137 just to name a few.

It has also been well reported that while several reasonably acceptable techniques exist for applying such coatings, one of the most efficacious, and thus preferred, is the well known technique referred to as "magnetically enhanced sputter-coating". Such a technique is reported in U. S. Patent No. 4,166,018, a recognized fundamental teaching on the subject. (See also, Munz et al. "Performance and Sputtering Criteria of Modern Architectural Glass Coatings" SPIE Vol. 325 Optical Thin Films, 1982, pg. 65-73.) While efficacious, for many known layer systems its use may result in mechanical durability being less than that achieved by another known method called the "pyrolytic" technique. As a reverse function, however, sputter-coated systems often achieve better infrared reflectance than typical pyrolytic coatings.

Because of the popularity of these coated glasses, numerous companies have entered the marketplace in recent years. Some of these glasses are sputter-coated. Others are coated by other techniques such as the pyrolytic process. Some are bent, others are flat. The precise compositions of many of these coated glasses is not known. However, what is known is that none of them achieve the characteristics which it is an object of this invention to produce, nor do they appear to employ the same unique combination of elements disclosed hereinafter that achieve these characteristics.

For example, one system that is generally known is the Leybold "Spectrum" windshield glass system know as TCC-2000. In this system four or five layers of metals and metal oxides are employed to obtain a sputter-coated glass which, being somewhat heat treatable at temperatures up to 1100°F (600°C), may be used as a pre-coated glass for making bent or unbent, glass windshields, provided rather rapid time limits are placed on the heat treatment. The layering from glass substrate outwardly usually includes a first layer of tin oxide, a second layer of a nickel/chromium alloy (usually about 80/20), a third layer of silver, a fourth layer of the nickel/chromium alloy, and a fifth layer of tin oxide. In addition to the rather low upper limit on heat treatment temperatures and times, the resultant coatings are rather soft and exhibit such unacceptably low chemical resistance characteristics that they can realistically be used only on the inner surfaces of laminated glass windshields. Leybold's other systems, such as its "Solar coatings" (sputter-coated $SnO_2/Cr/SnO_2$); "Low-E" (sputter-coating $SnO_2/Ag/Al/SnO_2$); and "Revised Architectural" (sputter-coated $SnO_2/Ag/NiCr/SnO_2$, NiCr being 80/20) have not proven to be heat treatable.

Exemplifying further prior knowledge are several systems (in the patents, as well as those marketed) which recognize that various oxides such as titanium dioxide, tin oxide, mixtures of tin oxide with other metal oxides (e.g. with ZnO) may be used as an efficacious overcoat or undercoat for durability and other properties. In addition, several recognize that aluminum, nickel and a wide variety of nickel-based alloys such as stainless steel (i.e. less than about 15% Ni), Inconel, etc., may be used as efficacious intermediate layers in sputter-coated glasses. Exemplary of these types of glasses include the following:

| Company | Trade Designation | Layer System (on Information and Belief) |
|---------|-------------------|------------------------------------------|
| PPG | Solarcool | single layer, heat treatable, non-sputter coated, $Cr_2O_3$ |
| | Solarban | stainless steel bearing, not heat treatable, sputter-coated, various oxides, nitrides and metals |
| | Sungate 100 | sputter-coated, not known to be heat treatable $(SnZn)O_2-Ag-Ti-(SnZn)O_2TiO$ |

| Ford | Sunglass Reflective | similar to PPG Solarcool single layer, unknown oxide |
| | Sunglass Hp Reflective | similar to Solarban |
| SPI | Sunglass HP Reflective | similar to Solarban |
| | Sunglass HR | sputter-coated, not known to be heat treatable, oxide-Ag-Metal-Oxide |
| LOF | Eclipse | pyrolitic, heat treatable, not sputter-coated |
| AIRCO | Solar Coatings | numerous sputter coatings of various oxides, nitrides and metals, including stainless steel (e.g. less than 15% Ni), none are heat treatable |
| | Architectural L.E. and Sunbelt L.E. | sputter-coated, not known to be heat treatable $ZnO_2-Ag-\overset{Ti}{ZN}-ZnO_2-TiO_2$ |
| | Aircool 72 & 76 | sputter-coated, non-durable, not known to be heat treatable $ZnO/Ag/Zn/ZnO/Ag/Zn/znO_x$ |

4

| | Airco Super-H (Heat Treatable) experimental | $SnO_x/Al/Ag/Al/SnO_x$ sputter-coated, non-durable, heat treatable |
|---|---|---|
| LEYBOLD | Solar coatings | sputter-coated, not heat treatable $SnO_x-CrN-SnO_x$ |
| | Low-E | sputter-coated, not known to be heat treatable $SnO_x-Ag-Al-SnO_x$ |
| | Revised Architectural | sputter-coated, not known to be heat treatable $SnO_x-Ag-NiCr-SnO_x$ (Ni/Cr is 80/20) |
| | TCC-2000 | discussed above. Heat treatable but not durable (Ni/Cr is 80/20) $SnO_x-NiCr-Ag-NiCr-SnO_x$ |
| GLAVERBEL | StopSol | single layer of unknown metallic oxides, heat treatable pyrolytic coating |

| | Prestige | sputter coatings of oxide-Ag-oxide, oxides unknown, not heat treatable or durable |
| --- | --- | --- |
| | Comfort | single layer of unknown metal oxide, heat treatable pyrolytic system |
| PILKINGTON | Reflecta Float | single layer of metallic oxide (possibly Cr or Ni containing) heat treatable pyrolytic, not sputter-coated |
| | Sputtered coatings | various layers of oxides, nitrides and metal, metal can be Ni bearing of 15% or less Ni, not heat treatable |
| ASAHI | (experimental) Sunroof coating | heat treatable, total constituents unknown, may have some Ni, most probably Ti and Al |

| GUARDIAN (Luxguard) | "S", "T", "C" series RP-20, Nu-52, LE-75, Appln. S. N. 077,226 filed 7/24/87 and now U.S. Patent No. _____ | various sputter-coated, non-heat treatable layer systems of oxides and/or metals. Oxides include $SnO_x$, $ZnO_2$, $TiO_2$ and the like as protective coatings. Typical metals are Cu, Ag, stainless steel (less than 15% Ni) and/or Ti. LE-75, for example, has included in the past in one embodiment an $SnO_x$-Cu-$SnO_x$ layer system which is not heat treatable. Modern LE-75 layers are more complex systems involving $TiO_2$, $ZnO_2$ and other non-nickel bearing metals. |
| FLACHGLASS (also St. Gobain) | Siglachrom | $(INSnO_x)/Pt/(INSnO_x)$ heat treatable<br><br>employs platinum which is expensive |
| | U.S. Patents No. 3,901,997;4,497,700 and 3,978,273 | various layers with Ag,Au or Cu coating including 80/20 Ni/Cr |

| Infrastop | sputter-coated, not heat treatable, various layers of oxides, nitrides and metals, some metals may contain 15% or less Ni |
| U.S. Patent No. 4,816,054 | metal silicide coating sputter-coated and said to be heat treatable |

(In the above listing tin oxide is indicated as $SnO_x$. At times in the prior art it is stated as $SnO_2$. No distinction is drawn herein between these two forms of reference for tin oxide.)

Of these glasses, perhaps three may be classified as coming closest to that disclosed hereinafter; namely, TCC-2000, Airco Super-H experimental and Siglachrom. TCC-2000's lack of durability and its drawbacks are discussed above. Siglachrom employs an indium-tin oxide combination as its first and third of three coatings. As its intermediate metallic layer it employs platinum. Airco Super-H experimental, while heat treatable, employs silver, and has been found to lack durability.

U. S. patent No. 4,790,922 discusses the difficulties which the prior art has experienced in attempting to develop coated glasses for architectural and automotive purposes which must be, or are desirably, put through their heat treatment step (e.g. tempering, bending, or both) after the coating is applied. The solution posed in this prior art patent is a rather complex layer system consisting of a first layer of an Sn/Zn oxide, a second layer of titanium, a third layer of silver or stainless steel, a fourth layer of titanium, a fifth layer of an Sn/Zn oxide, and a sixth, top layer of titanium oxide. The patent, while stating the material is heat treatable, acknowledges in Col. 4, line 56-57, that: "The glass can then be heated to approximately 1100 degrees fahrenheit ..." In addition to being a rather complex system, it relies upon titanium for three of its layers, and indeed its effectiveness. Titanium, experience shows, is a difficult (slow) element to sputter.

There are three different types of heat treatments that are generally employed to work glass for architectural or automotive purposes; namely, bending, tempering, and a lesser form of tempering called "heat strengthening". When bending without tempering conventional 1/4" (0.6 cm) clear float glass, for example, times of 10-30 minutes at 1150°F (620°C) or more are generally necessary to use. In heat strengthening or tempering such glass, with or without bending, temperatures as high as 1450°F (790°C) (e.g. 1150°F-1450°F [620°C-790°C]) are normally employed for about 2-5 minutes. As can be seen, there are significant drawbacks to the known or reported prior art techniques for providing heat treatable coated glass, particularly of the efficacious sputter-coated type.

Coated glasses for use in architectural or automotive design generally have eight (8) characteristics which determine their efficacy and/or marketability: commercial feasibility, durability (mechanical resistance to abrasion), chemical resistance, long-term stability, emissivity, transmittance, reflectivity and color. In prior systems, some of the characteristics had to be significantly impaired in order to achieve the necessary degree of acceptability for the remaining characteristics. For this and other reasons, therefore, it is apparent that there exists a need in the art for a heat treatable, coated glass useful in architectural and/or automotive design which does not unduly sacrifice the above eight (8) characteristics, and preferably, which also may be heat treated (i.e. bent, tempered, and/or heat-strengthened) at the upper temperature ranges and times of such treatments. There is also a need for such a coating to be formed by sputter-coating techniques, but which does not sacrifice mechanical durability as compared to pyrolytically formed coatings.

European Patent Application 0041463 describes a process for making semi-reflective metallized glasses in which an anchoring layer is deposited by vacuum evaporation from an alloy of 40-70% nickel, 5-31% chromium and 3-28% molybdenum with, optionally, at least one of tungsten, iron and cobalt. One or more layers may be deposited over the anchoring layer, including a further semi-reflective layer of gold, silver or copper and a dielectric layer of silicon dioxide, zinc sulfide or a mixed indium and tin oxide. There is no indication that the coating produced by the layers is heat treatable.

European Patent Application 0224704 describes a method for manufacture of a glass pane comprising coating at least one side of a glass substrate with an inner layer of a metal or metal alloy, the metal being one of the elements having atomic number 22-28, and an outer, protective layer of at least one metal, or mixed metal, oxide. The combination is then thermal prestressed and/or bent at a temperature of 580°C to 680°C. The protective layer has an oxygen deficiency, i.e., the oxide or oxides are sub-stoichiometric and a thickness of from 10 nm to 100 nm. The necessity for an oxygen deficiency means that very careful control is required when applying the protective layer.

Neither of these documents provide teachings which satisfy the above-described needs. It is, therefore, amongst the objects of this invention to fulfil the above-described needs, as well as other needs apparent to the skilled artisan from the following detailed description of this invention.

A coated glass article, in accordance with the invention, comprises a substrate of glass having coated thereon a coating system comprising a metallic oxide overcoat layer consisting essentially of stoichiometric $SnO_2$ and an intermediate metallic layer consisting essentially of nickel or a nickel alloy having at least 70% by weight nickel, wherein the article is capable of withstanding temperatures from 1150°F-1450°F (620°C-790°C) for times sufficient to bend and/or heat strengthen and/or temper the article without significant degradation of colour, durability, chemical resistance, emissivity, reflectance and transmittance as these characteristics are defined in terms of an automotive or architectural window.

A method of forming a heat treated glass article, in accordance with the invention, comprises coating on the surface of the glass article prior to heat treatment of a coating system comprising a metallic oxide overcoat layer consisting essentially of stoichiometric $SnO_2$ and an intermediate metallic layer consisting essentially of nickel or a nickel alloy having at least 70% by weight nickel and thereafter subjecting the coated glass article to a heat treatment at about 1150°F-1450°F (620°C-790°C) for times sufficient to bend and/or heat strength and/or temper the article without significant degradation of colour, durability, chemical resistance, emissivity, reflectance and transmittance as these characteristics are defined in terms of an automotive or architectural window.

Generally speaking, this invention fulfills the above-described needs in the art by providing a heat treatable article comprising a glass substrate having thereon a coating system consisting essentially of a metallic layer selected from nickel or a high nickel content alloy and as an overcoat therefor a layer of tin oxide.

In an alternative form there is further provided a layer of tin oxide as an undercoat layer for said metallic layer. In still another form, particularly preferred especially for automotive bent windshields, metallic aluminum overlays the nickel or Ni alloy layer and underlies the outer $SnO_2$ layer. In certain preferred forms no other layers or ingredients are provided, other than those described above with respect to the 2, 3, or 4-layered system.

Because the elements used in carrying out this invention, in their preferred forms, are all readily sputterable by known, conventional magnetically enhanced sputter-coating processes, this invention further fulfills the above-described needs in the art by providing a unique method for forming a heat treatable article comprising the steps of sputter-coating upon a glass substrate a coating system consisting essentially of a metallic layer selected from nickel or a high nickel content alloy and as an overcoat therefor a layer of tin oxide. As stated above, another layer of $SnO_2$ may be sputter-coated as a first, glass contacting layer. As further stated above, in particularly preferred embodiments, the method of this invention contemplates sputter-coating four layers which from glass outwardly are: $SnO_2$/Ni or Ni alloy/ Al/$SnO_2$.

None of these known glasses listed above achieves or recognises the particularly unique results that are obtained when only tin oxide is used as an overcoat (and also optionally as an undercoat as well) alone or with aluminum, together with nickel or a specific type of nickel alloy in a sputter-coating process. Unique heat treatable glasses are produced with excellent tolerance to temperatures above 1100°F (600°C) at times usually employed in non-coated glass heat treatments. Further, in preferred embodiments, the glasses are not only heat treatable, but durable (scratch resistant) as well. Such glasses, in fact, are so durable that there is no need to laminate them to protect the layer system from ordinary use.

In contrast to the teaching of the need to overcoat the Zn/Sn oxide fifth layer with $TiO_2$ of U.S. Patent 4790922, it has, unexpectedly, been found that when tin oxide is used alone or with aluminum, together with certain select nickel compounds, it overcomes the problems in the patented system, and there is, among other advantages, no need for a $TiO_2$ overcoat.

This invention will now be described with reference to certain preferred embodiments thereof along with illustrations found in the accompanying drawings wherein:

Figure 1 is a partial side-sectional view of a two-layer coating system according to certain embodiments of this invention.

Figure 2 is a partial side-sectional view of a three-layer coating system according to certain embodiments of this invention.

Figure 3 is a partial side-sectional view of a four-layer coating system according to certain embodiments of this invention.

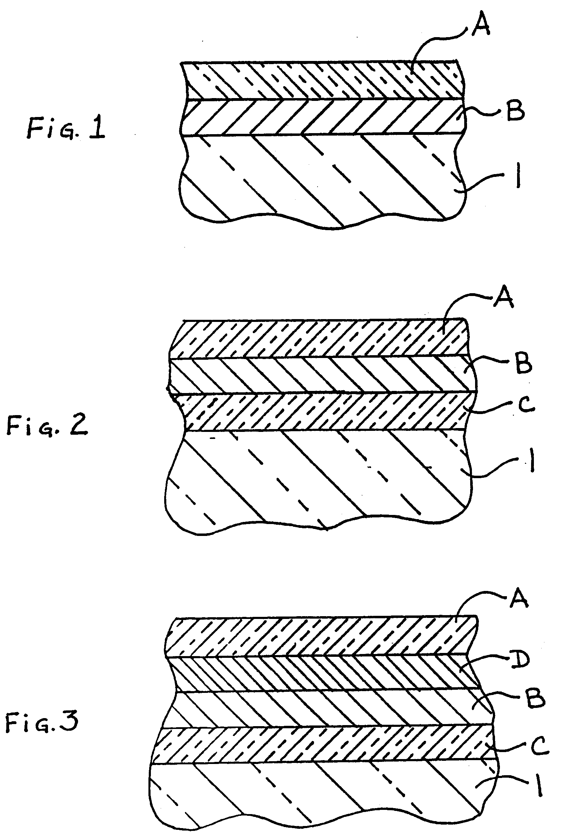

Reference to the accompanying drawings Figures 1-3, shows that the preferred coatings of this invention consist essentially of 2, 3, or 4 layers sputter-coated onto glass. In the two-layer system (Fig. 1) a glass substrate 1 has sputter-coated upon it an adhering metallic layer B consisting essentially of nickel or a high nickel content alloy (i.e. at least about 50% Ni). Thereafter, overcoat layer A consisting essentially of tin oxide (SnOx) is sputter-coated thereover. The three-layered system (Fig. 2) is the same, except that an initial layer C consists essentially of the same tin oxide used as the overcoat layer A in Fig. 1 with the nickel or high nickel content alloy sandwiched as layer B between the two tin oxide layers A and C. The four-layered system (Fig. 3) is the same, except that overlaying metallic layer B is another sputter-coated layer of metallic aluminum. It has been found that tin oxide, when sputter-coated from a tin cathode as layer C in an oxygen-containing environment according to conventional sputter-coating techniques, forms an excellent, durable bond with both glass substrate 1 and the Ni-containing metallic layer as contemplated by this invention. It has also been found that when sputter-coated as an overcoating (with or without $SnO_x$ as an undercoat) this same oxide, when used with the specified metallic layer B, renders the system heat treatable and durable. It has further been found, quite unexpectedly, that if metallic aluminum is sputter-coated as layer D, the heat treatableness and durability are further enhanced significantly.

The glasses useful in this invention may be of a wide variety, and may be tinted or untinted. Efficacious are untinted or gray tinted glass sheets made by the well known float process, and referred to as float glass. Such glasses may be bent or used flat, and may be heat strengthened, or tempered, with, or without bending to form a wide variety of structures from decorative, colored low emissivity, transparent, window panes for buildings, to "privacy" windshields in cars. In this respect, in the preferred embodiments the final structure is highly durable, particularly when layer D is employed, such that the glass, without lamination, is useful as an automotive window.

The coating technique useful and preferred is the well known in-line magnetically enhanced sputter-coating process and equipment available from Airco-Temescal, the basic technique of which is disclosed in the aforesaid U. S. Patent 4,166,018.

While the invention herein is not necessarily limited to 2, 3, or 4 layers, any layer added must not interfere adversely with the heat treatable characteristic of the coated glass formed. Thus the term "consisting essentially of" as used to describe the coating systems is intended to exclude any layer which, if used, would deteriorate adversely the heat treatable nature of the products of this invention. For example, it has been found, as evidenced by the "Spectrum" coatings referred to above, that if silver is used as a layer, heat treatability is severely deteriorated, unless the most preferred nickel alloys of this invention (e.g. ones containing Ni, Fe, Cr, C, Al, and Y) are used.

The term "consisting essentially of" when used to describe the tin oxide undercoat and/or overcoat layers of this invention, and to describe the metallic aluminum layer, is used in a similar way. Tin oxide ($SnO_x$) is not alloyed or mixed in the preferred embodiments of this invention. Neither is the aluminum. Excepted from this, of course, are minor "impurities" that may inherently occur in the tin or aluminum of the cathode employed. However, if other metals or oxides are employed, it is a requirement that any such other metals or oxides added do not deteriorate adversely from the heat treatable nature of the products of this invention. For example, the use of antimony (Sb) with the tin was found to be unsatisfactory since it resulted in 15-20 unit changes in reflectance/transmittance characteristics during heat treating. ZnO itself was found to be unsuitable, as another example. Thus, while it is possible that small amounts of some other metals may be tolerated in the tin oxide; the undercoat, and particularly the overcoat, should generally only include tin oxide by itself. The same holds true for the metallic aluminum layer when employed.

A wide variety of sputterable nickel alloys, and nickel itself, have been reported or used in the past as coatings on glasses. The subject invention achieves its unique characteristics, however, by using only a particular type of nickel alloy, referred to herein as nickel or a "high nickel content alloy". Again, the term "consisting essentially of" is used to define this layer in the same way it defined the tin oxide and aluminum layers referred to above. Generally speaking, the high nickel content alloy should be a Ni-Cr-Fe alloy having a nickel content of at least about 50%, and preferably at least about 70%. "Pure" nickel may be used, but it is difficult to sputter in production. Thus it is preferable to use an alloy, and in this respect preferably one having no more than about 90% Ni. It has been found that nickel alloys having less than about 50% Ni, e.g. 316-stainless steel (8% Ni) are simply unacceptable and do not achieve the desired characteristics of this invention. Examples of high nickel content alloys contemplated for use in this invention include Inconel 600, Inconel 601, 50-50 nickel chrome and 80-20 nickel chrome.

A particularly preferred alloy for use in practicing this invention is a high content nickel alloy consisting essentially of Ni, Cr, Fe, C, Al and Y (i.e. yttrium). In this respect, it has been found that a preferred six-member alloy of this type includes by weight %: about 76% Ni, about 4% Fe, about 16% Cr, less than about 0.5% C, about 5% Al, and less than about 0.1% Y. Particularly good results, in fact, are achieved with such an alloy, available in commercial form as Haynes® Alloy No. 214. The composition of such an alloy is:

| Element | Approx. ("about") % by wt. |
|---------|---------------------------|
| Ni | 75.45 |
| Fe | 4.00 |
| Cr | 16.00 |
| C | .04 |
| Al | 4.50 |
| Y | .01 |

The coatings of this invention are heat treatable. In the preferred forms, emissivity, transmittance, and reflectivity (the latter two viewed from both sides of the glass) vary by about 10 units or less during the heat treatment, preferably less than about 8 units, and in some instances less than about 1 unit, while maintaining excellent durability, chemical resistance, and long-term stability. This is true despite the fact that conventional times and temperatures (above 1100°F. (600°C), e.g. 1150°F.-1450°F. (620°C - 790°C) are used during the heat treatment (e.g. bending, tempering or heat strengthening, or the latter two with bending). Indeed, it is a unique feature of this invention that in many embodiments it will be found that these characteristics actually improve with heat treating, and that the color is actually advantageously improved (i.e. becomes more neutral) with heat treatment. For example, in certain preferred embodiments using Haynes® Alloy No. 214 and one or two unalloyed tin oxide layers, color by the $(Y, \bar{x}, \bar{y})$ system goes from 28.00, .3250, .3250 respectively to 21.00, .3150, .3150 respectively.

A typical two-layered system according to Fig. 1 would be a float glass sheet as substrate 1 having a thickness of about 3/32" - 1/2" (0.25 - 1.25 cm), a high nickel content Ni, Cr, Fe alloy of about 50Å - 250Å (preferably about 150Å) as layer B, and a tin oxide overcoat layer of 20Å - 500Å (and preferably about 160Å) as layer A. The three-layer system of Fig. 2 is the same, except a very thin (e.g. a "flash" coating of a few Angstroms) to 500Å (preferably about 160Å) layer of tin oxide is used as layer C. The four-layered system of Fig. 3 is the same except a metallic layer of aluminum of about 5Å-500Å (preferably about 60Å) is used as layer D. ("5Å" is meant to indicate a very thin layer of Al.)

While the precise mechanism by which the unique characteristics of this invention are achieved is not fully understood, it is believed that the various layers serve at least the following purposes, and thus may be varied in thickness by the routineer in the art once given this disclosure, to fine tune his particular system to the particular characteristics desired.

| Layer A: | a) Reduces oxidation of metallic layer 'B' during heat treatment<br>b) Reduces abrasion of metallic layer 'B' prior to heat treatment<br>c) Increases chemical resistance of layer system<br>d) Adjusts optical characteristics of layer system, (transmission, reflectance, reflected color) |
|---|---|
| Layer B: | a) Reflects infrared radiation<br>b) Reflects visible light<br>c) Reduces solar energy transmission<br>d) Reduces visible light transmission<br>e) Resists high temperature oxidation during heat treatment |
| Layer C: (optional) | a) Reduces visible light reflectance (anti-reflective layer)<br>b) Reduces layer B to glass interaction at high temperature<br>c) Increases chemical resistance of layer system<br>d) Adjusts optical characteristics of layer system, (transmission, reflectance, reflected color) |
| Layer D: (optional) | a) retards oxidation of layer B during heat treatment<br>b) enhances durability (i.e. scratch or abrasion resistance) |

As stated above, the preferred process to be used in manufacturing the coated glass structures of this invention is sputter-coating. Typical processing parameters for an Airco-Temescal, 3-zone, 9 cathode position architectural coater are:

| Layer A: | Working Gases:<br>Gas Pressure:<br>Target Voltage:<br>Target Amperage: | Argon and Oxygen (ratios variable up to 100% $O_2$)<br>0.5 to 5.0 x $10^{-3}$ Torr (0.06 to 0.6 N/m$^2$)<br>Varies (Approx. 200-800 volts)<br>Varies |
|---|---|---|
| Layer B: | Working Gas:<br>Gas Pressure:<br>Target Voltage:<br>Target Amperage: | Argon (100%)<br>0.5 to 5.0 x $10^{-3}$ Torr (0.06 to 0.6 N/m$^2$)<br>Varies (Approx. 200-800 volts)<br>Varies |
| Layer C: (optional) | Working Gases:<br>Gas Pressure:<br>Target Voltage:<br>Target Amperage: | Argon and Oxygen<br>(ratios variable up to 100% $O_2$)<br>Varies (Approx. 200-800 volts)<br>Varies |
| Layer D: (optional) | Working Gases:<br>Gas Pressure:<br>Target Voltage:<br>Target Amperage: | Argon (100%)<br>0.5 to 5.0 x $10^{-3}$ Torr (0.06 to 0.6 N/m$^2$)<br>Varies (Approx. 200-800 volts)<br>Varies |

When 1/4" (0.65 cm) clear float glass is coated in accordance with the above process and heated to 1200°F (650°C). for 15 minutes, the resulting properties of the coated glass produced are typically:

FIG. 1

2-LAYER COATING

| Visible Transmission: | 0 - 50% | Illuminate 'C' |
|---|---|---|
| Visible Reflectance: | 10 - 65%<br>5 - 60% | Coated Side, Ill. 'C'<br>Glass Side, Ill. 'C' |
| Visible Color: | Pewter to Bronze (film side) ||
| Visible Color: | Silver to Bronze (glass side) ||
| Emissivity: | 0.10 -0.60 (varies with metal thickness) ||
| Sheet Resistance: | 10 -200 OHMS per square (varies with metal thickness) ||

FIG. 2

3-LAYER COATING

| Visible Transmission: | 0 - 60% | Illuminate 'C' |
|---|---|---|
| Visible Reflectance: | 10 - 60%<br>5 - 55% | Coated Side, Ill. 'C'<br>Glass Side, Ill. 'C' |
| Visible Color: | Silver to Bronze (film side) ||
| Visible Color: | Pewter to Blue (glass side) ||
| Emissivity: | 0.10 - 0.60 (varies with metal thickness) ||
| Sheet Resistance: | 10 - 200 OHMS per square (varies with metal thickness) ||

FIG. 3

4-LAYER COATING

| Visible Transmission: | 0 - 75% | Illuminate 'C' |
|---|---|---|
| Visible Reflectance: | 5 - 65%<br>5 - 65% | Coated Side, Ill. 'C'<br>Glass Side, Ill. 'C' |
| Visible Color: | Silver to Bronze (film side) ||
| Visible Color: | Pewter to Blue (glass side) ||
| Emissivity: | 0.10 - 0.70 (varies with metal thickness) ||
| Sheet Resistance: | 10 - 500 OHMS per square (varies with metal thickness) ||

In addition to the above, many of the glasses contemplated herein exhibit excellent U-V resistance. Furthermore, there is no requirement that the glass substrate be float glass, or even clear glass. The invention is applicable to a wide variety of glasses (or even glass ceramics) which may, if desired, be tinted; e.g. gray, green or the like.

This invention will now be described with reference to certain examples, as follows:

13

EXAMPLE 1

A multilayer thin film coating is deposited on a substrate of soda lime silica float glass which is capable of withstanding process temperatures as high as 1450°F. (788°C.) for approximately 5 minutes.

In this example a 3 (0.9m) by 4 feet (1.22m), 3/16 inch (4.8mm) gray tinted glass substrate with a visible daylight transmittance of 49% as measured at a wave length of 550 nanometers, is coated with a three-layer thin film coating by the magnetron sputtering method as developed by Airco-Temescal. The coating layers are applied in succession using a three-zone architectural coater available from Airco-Temescal. Prior to coating, the glass is washed by two conventional flat glass washers positioned in series to the architectural coater.

The first coating zone is equipped with two tin cathodes (99.9% tin) which run the width of the coater. The tin cathodes are installed in positions 1 and 2 with position 3 being reserved for a cathode material which would enable applying other types of coatings. The nominal base pressure of $5.0 \times 10^{-6}$ Torr (0.6 $N/m^2$) for Zone 1 is increased to a sputtering pressure of $2.0 \times 10^{-3}$ Torr (0.24 $N/m^2$) by bleeding in 700 Sccm of a pre-mixed 80% oxygen and 20% argon gas. The sputtering pressure is further sublimated with a pure argon flow of 176 Sccm. Both cathodes are powered by 120 kw DC power supplies set for 369 volts and 35 amps. The glass is conveyed through the coater at a line speed of 54.0 inches/minute (1.37 cm/min). A visible light transmission monitor positioned at the end of Zone 1 recorded a reading of 48.5% transmission. The resultant coating layer at this point is an anti-reflective coating of $SNO_X$. The glass side reflectance of the three-layer thin film coating can be decreased by increasing the thickness of the 1st layer of $SNO_X$. The primary function of this layer is the control of reflectance and color. Its contribution to the heat resistance of the total layer system is not substantial.

The second coating zone is equipped with one cathode of Haynes® Alloy No. 214 in position 5. Positions 4 and 6 are reserved for cathode materials which would enable applying other types of coatings. At the line speed mentioned above, the gray glass passes under the Haynes® Alloy No. 214 and a visible light transmission of 7.5% is recorded at the end of Zone 2. The "214" cathode is powered by a 120 kw DC power supply set for 476 volts and 19.0 amps. The "214" cathode is sputtered in an atmosphere which the nominal base pressure of $5.0 \times 10^{-6}$ Torr (0.6 $Nm^2$) for Zone 2 is increased to a sputtering pressure of $2.0 \times 10^{-3}$ (0.24 $N/m^2$) by bleeding in 640 Sccm of argon gas. The primary function of the "214" layer is to control transmission, provide thermal performance and resist oxidation at the process temperatures mentioned above.

The third coating zone is equipped with one cathode of tin in position 7. Positions 8 and 9 are reserved for cathode materials which would enable applying other types of coatings. Continuing at the pre-set line speed of 54 inches/minute (137 cm/min), a second layer of $SnO_x$ is sputtered over the existing 2-layer coating. As in Zone 1, a 120 kw DC power supply is used to power the tin cathode. The power supply is set for 434 volts and 50.0 amps. The nominal base pressure of $5.0 \times 10^{-6}$ Torr (0.6 $N/m^2$) for Zone 3 is increased to a sputtering pressure of $2.0 \times 10^{-3}$ (0.24 $N/m^2$) Torr by bleeding in 620 Sccm of a pre-mixed 80% oxygen and 20% argon gas. The sputtering pressure is further sublimated with a pure argon flow of 154 Sccm. The three-layer coating passes under a visible light transmission monitor at the end of Zone 3 and a reading of 10.7% is recorded. The primary function of the third layer system is to protect the "214" layer from corrosion at the process temperatures mentioned above, in addition to enhancing color and improving mechanical durability of the completed layer system. The coated glass is inspected for coating defects and the optical properties are evaluated using a colorimeter as manufactured by Spectrogard. In this example, a glass side visible reflectance of 11.0% and glass side chromaticity color coordinates of $\bar{x}$ = .3120, $\bar{y}$ = .3145 are recorded.

At this point the three-layer coating on gray tinted glass is ready for further processing into an automotive side lite (privacy window). Except for slight modifications to the tempering process, which would be common knowledge to someone versed in tempering, the glass may be cut, ground, silk screened, heated, bent and tempered by processes normal to the manufacture of automotive side lites. For example, the above-coated glass is first cut to required size and edged to customer's requirement, including the application of a ceramic frit border if required. The structure is then heated at a moderate rate to approximately 1150°F. (620°C.), depending on the glass thickness and bent to the required shape. The glass is then cooled rapidly with air to temper it and cool it to handling temperatures. The time at which the structure is held above 1150°F (620°C). is 2-5 minutes. However, the structure so formed may tolerate temperatures up to about 1450°F (790°C). for 5 minutes if necessary to effect the bending and/or tempering process.

14

EXAMPLE 2

In this example, a 28 inch (0.71m) by 38 inch (9.97m), 5/32 inch (4mm) clear glass substrate with a visible daylight transmittance of 90%, as measured at a wave length of 550 nanometers, is coated with a two-layer thin film coating in a similar fashion as described in Example 1. The coating layers are applied in succession using two of the three zones of the architectural coater available from Airco-Temescal.

All cathode power and process gases are turned off in zone 1. The clear glass is conveyed through the coater at a line speed of 54.5 inches/minute passing through zone 1 unaltered.

At this time, the glass enters zone 2 which is equipped with one Haynes® Alloy No. 214 in position 5 as described in Example 1. The "214" cathode is powered by a 120 kw DC power supply set for 513 volts and 47.0 amps. The "214" cathode is sputtered in an atmosphere with the nominal base pressure of $5.0x10^{-6}$ Torr (0.6 N/m$^2$) for zone 2 increased to a sputtering pressure of $2.0x10^{-3}$ (0.24 N/m$^2$) by bleeding in 652 Sccm or argon gas. A visible light transmittance of 2.9% is recorded on the transmission monitor at the end of zone 2. As described in Example 1, the primary function of the "214" layer is to control transmission, provide thermal performance and resist oxidation at a process temperature of 1450°F. (788°C.) for approximately 5 minutes.

The clear glass is now conveyed to zone 3 which is equipped with one cathode of tin in position 7 as described in Example 1. With the conveyor line speed set at 54.5 inches/minute (138 cm/min), a layer of $SNO_X$ is sputtered over the existing Haynes® Alloy No. 214. The tin cathode is powered by a 120 kw DC power supply set for 443 volts and 50 amps. The nominal base pressure of $5.0x10^{-6}$ Torr (0.6 N/m$^2$) for zone 3 is increased to a sputtering pressure of $2.0x10^{-3}$ Torr (0.24 N/m$^2$) by bleeding in 691 Sccm of a pre-mixed 80% oxygen and 20% argon gas. The sputtering pressure is further sublimated with a pure argon flow of 173 Sccm. The two-layer coating passes under a visible light transmission monitor at the end of zone 3 and a reading of 4.0% is recorded. As described in Example 1, the primary function of the $SNO_X$ top layer is to protect the "214" layer from corrosion at the process temperatures mentioned previously, in addition to enhancing color and improving mechanical durability of the completed layer system. The coated glass is inspected for coating defects and the optical properties are evaluated using a colorimeter as manufactured by Spectrogard. In the example, a glass side visible reflectance of 50.62 and glass side chromaticity color coordinates of $\bar{x} = .3141$, $\bar{y} = .3249$ are recorded.

At this point, the two-layer coating on clear glass is ready for further processing into an automotive sunroof. In such a process, the glass is cut and shaped as in Example 1, but to fit the sunroof configuration. Heating, bending and tempering may take place using conventional techniques, employing temperatures on the order of about 1300°F (700°C). for approximately 2-5 minutes as needed with degradation being no more than 10 units of the emissivity, transmission and reflectance characteristics of the sunroof. In addition, the resulting roof exhibits excellent durability and chemical resistance characteristics, as well as a pleasingly aesthetic silver color from the glass side (outside of the automobile) and an almost unnoticeable bronze reflected color to an occupant of the car.

EXAMPLE 3

In this example, a 1/4 inch (6mm) thick clear float glass substrate is coated in a similar fashion as illustrated in Example 2. A slight increase in transmission (approximately a 2% increase) is made by decreasing the current (amps) set point on the Haynes® Alloy No. 214 in zone 2. In changing the current, slight adjustments to the argon bleed may be necessary to maintain a $2.0x10^{-3}$ Torr (0.24 N/m$^2$) sputtering pressure. The parameters illustrated for the $SNO_X$ sputtered in zone 3 may also require slight adjustments to assure final color of the complete 2-layer architectural coating.

The resultant product is an architectural window (spandrel or vision) which, when heated to temperatures normal for bending architectural glass (e.g. about 1120°F (605°C). or more, at times of about 10-30 minutes), has similar optical characteristics as other high performance, but not heat treatable, sputtered architectural glasses such as Guardian's SS-8. (e.g. an 8% Ni-based stainless steel coating system overcoated with TiN.)

The advantage to the architectural glass in this example is that it can be bent, tempered or heat strengthened. This glass can also be bent and annealed if desired. In all cases, the architectural glass can be laminated if necessary.

EXAMPLE 4

In this example, a 3 (0.9mm) by 4 foot (1.22mm), 5/32 inch (4.8mm) gray tinted glass substrate with a visible daylight transmittance of 53.0 as measured at a wave length of 550 nanometers, is coated with a four-layer thin film coating in a similar manner as described for the three-layer film coating in Example 1.

The first coating zone is equipped with two tin cathodes (99.9% tin) and installed in positions 1 and 2. The nominal base pressure of $5.0 \times 10^{-6}$ Torr (0.6 N/m$^2$) for zone 1 is increased to a sputtering pressure of $2.0 \times 10^{-3}$ Torr (0.24 N/m$^2$) by bleeding in 893 Sccm of a pre-mixed 80% oxygen and 20% argon gas. The sputtering pressure is further sublimated with a pure Argon flow of 222 Sccm. Both cathodes are powered by 120 KW DC power supplies set for 391 volts, 41 amps and 379 volts, 41 amps, respectively. The glass is conveyed through the coater at a line speed of 62.6 inches/minute (159 cm/min). A visible light transmission monitor positioned at the end of Zone 1 recorded a reading of 48.2%. As in Example 1, the resultant coating layer at this point is an anti-reflective coating of SnOx.

The second coating zone is equipped with one cathode of Haynes® Alloy No. 214 in position 5 and an aluminum cathode (99.5% Aluminum) in position 6. Position 4 is reserved for cathode materials which would enable applying other types of coatings. At the line speed mentioned above, the gray glass passes under the Haynes® Alloy No. 214 and the aluminum where a visible transmission of 4.5% is recorded. The "214" cathode is powered by a 120 KW DC power supply set for 457 volts and 23.5 amps. The aluminum target is powered by a 120 KW DC power supply set at 324 volts and 13 amps. Both cathodes are sputtered in an atmosphere which the nominal base pressure of $5.0 \times 10^{-6}$ Torr (0.6 N/m$^2$) for Zone 2 is increased to a sputtering pressure of $2.0 \times 10^{-3}$ Torr (0.24 N/m$^2$) by bleeding in 840 Sccm of argon gas. The primary function of the "214" layer is the same as stated in Example 1. The primary function of the aluminum is to retard the oxidation of the "214" layer during heat treatment, therefore, increasing the heat stability of the total layer system. Abrasion and scratch resistance is enhanced as well.

The third coating zone is equipped with one tin cathode in position 7 and one tin target in position 8. Position 9 is reserved for cathode materials which would enable applying other types of coatings. Continuing at the pre-set line speed of 62.6 inches/minute, a second layer of SnOx is sputter-coated over the existing 3-layer coating. As in Zone 1, a 120 KW DC power supply is used to power the tin cathodes. The power supplies are set at 582 volts, 35 amps and 372 volts, 40 amps, respectively. The for Zone 3 is increased nominal base pressure of $5.0 \times 10^{-6}$ Torr (0.6 N/m$^2$) to a sputtering pressure of $2.0 \times 10^{-3}$ (0.24 N/m$^2$) Torr by bleeding in 849 Sccm of pre-mixed 80% oxygen and 20% Argon gas. The sputtering pressure is further sublimated with a pure Argon flow of 212 Sccm. The four-layer coating passes under a visible light transmission monitor at the end of Zone 3 and a reading of 7.2% is recorded. The primary function of the fourth layer (SnOx) is the same as stated for the third layer (SnOx) in Example 1. The coated glass is inspected for coating defects and the optical properties are evaluated using a colorimeter as manufactured by Spectrograd. In this example, a glass side visible reflectance of 15.51 and glass side chromaticity color coordinates of $\bar{x}$ = .3176, $\bar{y}$ = .3234 are recorded. The thicknesses of the four layers are approximately:

| Layer | Angstroms |
|-------|-----------|
| A | 160Å |
| B | 150Å |
| C | 60Å |
| D | 160Å (1Å $= 10^{-8}$cm). |

At this point, the four-layer coating on 5/32 gray tinted glass is ready for further processing into an automotive side lite (privacy window) in a similar manner as set forth in Example 1.

**Claims**

1.  A coated glass article comprising a substrate of glass having coated thereon a coating system comprising a metallic oxide overcoat layer consisting essentially of stoichiometric $SnO_2$ and an intermediate metallic layer consisting essentially of nickel or a nickel alloy having at least 70% by weight nickel, wherein the article is capable of withstanding temperatures from 620°C-790°C (1150°F-1450°F) for times sufficient to bend and/or heat strengthen and/or temper the article without significant degradation of colour, durability, chemical resistance, emissivity, reflectance and transmittance as these characteristics are defined in terms of an automotive or architectural window.

2.  A method of forming a heat treated glass article comprising coating on the surface of the glass article prior to heat treatment of a coating system comprising a metallic oxide overcoat layer consisting essentially of stoichiometric $SnO_2$ and an intermediate metallic layer consisting essentially of nickel or a nickel alloy having at least 70% by weight nickel and thereafter subjecting the coated glass article to a heat treatment at about 620°C-790°C (1150°F-1450°F) for times sufficient to bend and/or heat strength and/or temper the article without significant degradation of colour, durability, chemical resistance, emissivity, reflectance and transmittance as these characteristics are defined in terms of an automotive or architectural window.

3.  An article as claimed in Claim 1 or a method as claimed in Claim 2, wherein the coating system further comprises, as an undercoat layer for the metallic layer, a layer consisting essentially of stoichiometric $SnO_2$.

4.  An article as claimed in Claim 1 or Claim 3 or a method as claimed in Claim 2 or Claim 3, wherein the glass substrate is 2.4 mm-12.7 mm (3/32"-1/2") float glass, and the metallic nickel or high nickel content alloy layer has a thickness of about 50Å-250Å, preferably 150Å.

5.  An article as claimed in any one of Claims 1, 3 or 4 or a method as claimed in any one of Claims 2 to 4, wherein the $SnO_2$ layer has a thickness of from about a few angstroms to about 500Å, preferably 160Å.

6.  An article as claimed in any one of Claims 1 or 3 to 5 or a method as claimed in any one of Claims 2 to 5, wherein the coating system further comprises, as a layer intermediate the overcoat of $SnO_2$ and the metallic layer selected from nickel or a high nickel content alloy, a second metallic layer consisting essentially of aluminium.

7.  An article as claimed in any one of Claims 1 or 3 to 6 or a method as claimed in any one of Claims 2 to 6, wherein the second metallic layer has a thickness of from about a few angstroms to about 500Å, preferably 60Å.

8.  An article as claimed in any one of Claims 1 or 3 to 7 or a method as claimed in any one of Claims 2 to 7, wherein the metallic layer is a high nickel content alloy comprised of nickel, chromium, and iron and wherein the nickel content is no more than 90% by weight.

9.  An article or a method as claimed in Claim 8, wherein the high nickel content alloy consists essentially of Ni, Fe, Cr, C, Al and Y.

10. An article or method as claimed in Claim 8 or Claim 9, wherein the metallic alloy consists essentially of, by weight: 76% Ni, 4% Fe, 16% Cr, less than 0.5% C, 5% Al, and less than 0.1% Y.

11. An article or a method as claimed in any one of Claims 8 to 10, wherein the high nickel content alloy consists essentially of by weight:

| Element | % |
|---------|-------|
| Ni | 75.45 |
| Fe | 4.00 |
| Cr | 16.00 |
| C | 0.04 |
| Al | 4.50 |
| Y | 0.01 |

12. A method as claimed in any one of Claims 2 to 11, wherein each of the layers of the coating system is formed by sputter-coating.

13. A method as claimed in Claim 12, wherein the sputter-coating is magnetically enhanced.

17

**14.** A method as claimed in either Claim 12 or Claim 13, wherein the SnO$_2$ layer is sputter-coated in an oxygen-containing environment by using an essentially pure tin cathode.

**Patentansprüche**

**1.** Beschichteter Glasgegenstand, der ein Substrat aus Glas mit einem darauf aufgebrachten Beschichtungssystem umfaßt, das folgendes aufweist: eine metallische Oxidüberschicht, die im wesentlichen aus stöchiometrischem SnO$_2$ besteht, und eine metallische Zwischenschicht, die im wesentlichen aus Nickel oder einer Nickellegierung mit mindestens 70 Gew.-% Nickel aufweist, wobei der Gegenstand in der Lage ist, Temperaturen von 620°C-790°C (1150°F-1450°F) für Zeiten standzuhalten, die ausreichen, den Gegenstand zu biegen und/oder durch Hochtemperatur zu verfestigen und/oder zu härten ohne die Farbe, die Haltbarkeit, die chemische Widerstandsfähigkeit, den Emissionsgrad, den Reflexionsfaktor und den Durchlässigkeitsfaktor, so wie diese Kenndaten im Bereich eines Kraftfahrzeug- oder Architekturfensters definiert sind, wesentlich herabzusetzen.

**2.** Verfahren zum Bilden eines hochtemperaturbehandelten Glasgegenstands, das folgendes aufweist: Beschichten der Oberfläche des Glasgegenstands vor der Hochtemperaturbehandlung eines Beschichtungssystems, das eine metallische Oxidüberschicht aufweist, die im wesentlichen aus stöchiometrischem SnO$_2$ und einer metallischen Zwischenschicht besteht, die im wesentlichen aus Nickel oder einer Nickellegierung mit mindestens 70 Gew.-% Nickel besteht, und danach Unterwerfen des beschichteten Glasgegenstands einer Hochtemperaturbehandlung bei ungefähr 620°C-790°C (1150°F-1450°F) für Zeiten, die ausreichen, den Gegenstand zu biegen und/oder durch Hochtemperatur zu verfestigen und/oder zu härten, ohne die Farbe, die Haltbarkeit, die chemische Widerstandsfähigkeit, den Emissionsgrad, den Reflexionsfaktor und den Durchlässigkeitsfaktor, so wie diese Kenndaten im Bereich eines Kraftfahrzeug- oder Architekturfensters definiert sind, wesentlich herabzusetzen.

**3.** Gegenstand nach Anspruch 1 oder Verfahren nach Anspruch 2,
wobei das Beschichtungssystem weiterhin eine Schicht als Unterschicht für die metallische Schicht aufweist, die im wesentlichen aus stöchiometrischen SnO$_2$ besteht.

**4.** Gegenstand nach Anspruch 1 oder 3 oder Verfahren nach Anspruch 2 oder 3,
wobei das Glassubstrat 2,4mm - 12,7mm (3/32" - 1/2") dickes Floatglas ist und das metallische Nickel oder die Legierung mit hohem Nickelgehalt eine Dicke von ungefähr 50Å - 250Å, vorzugsweise 150Å, aufweist.

**5.** Gegenstand nach einem der Ansprüche 1, 3 oder 4 oder Verfahren nach einem der Ansprüche 2 bis 4,
wobei die SnO$_2$-Schicht eine Dicke von ungefähr einigen wenigen Ångström bis ungefähr 500Å, vorzugsweise 160Å, aufweist.

**6.** Gegenstand nach einem der Ansprüche 1 oder 3 bis 5 oder Verfahren nach einem der Ansprüche 2 bis 5,
wobei das Beschichtungssystem weiterhin eine zweite metallische Schicht aufweist, die im wesentlichen aus Aluminium besteht und als eine Schicht zwischen der Überschicht SnO$_2$ und der metallischen Schicht ausgewählt aus Nickel oder einer Legierung mit hohem Nickelgehalt dient.

**7.** Gegenstand nach einem der Ansprüche 1 oder 3 bis 6 oder Verfahren nach einem der Ansprüche 2 bis 6,
wobei die zweite metallische Schicht eine Dicke von ungefähr einigen wenigen Angström bis ungefähr 500Å, vorzugsweise 60Å, aufweist.

**8.** Gegenstand nach einem der Ansprüche 1 oder 3 bis 7 oder Verfahren nach einem der Ansprüche 2 bis 7,
wobei die metallische Schicht eine Legierung mit hohem Nickelgehalt ist, die Nickel, Chrom und Eisen aufweist und wobei der Nickelgehalt nicht mehr als 90 Gew.-% beträgt.

**9.** Gegenstand oder Verfahren nach Anspruch 8,
wobei die Legierung mit hohem Nickelgehalt im wesentlichen aus Ni, Fe, Cr, C, Al und Y besteht.

**10.** Gegenstand oder Verfahren nach Anspruch 8 oder 9,
wobei die metallische Legierung im wesentlichen aus folgendem in Gew.-% besteht: 76% Ni, 4% Fe, 16% Cr, weniger als 0,5% C, 5% Al und weniger als 0,1% Y.

**11.** Gegenstand oder Verfahren nach einem der Ansprüche 8 bis 10,
wobei die Legierung mit hohem Nickelgehalt im wesentlichen aus folgendem in Gew.-% besteht:

| Element | % |
|---------|-------|
| Ni | 75,45 |
| Fe | 4,00 |
| Cr | 16,00 |
| C | 0,04 |
| Al | 4,50 |
| Y | 0,01 |

**12.** Verfahren nach einem der Anprüche 2 bis 11,
wobei jede der Schichten des Beschichtungssystems durch Sputterbeschichtung gebildet wird.

**13.** Verfahren nach Anspruch 12,
wobei die Sputterbeschichtung magnetisch verstärkt wird.

**14.** Verfahren nach Anspruch 12 oder 13,
wobei die $SnO_2$-Schicht in einer Sauerstoff enthaltenden Umgebung unter Verwendung einer im wesentlichen reinen Zinnkathode sputterbeschichtet wird.

**Revendications**

**1.** Article en verre recouvert, comprenant un substrat en verre comportant un système de revêtement comprenant une couche de revêtement supérieur, d'oxyde métallique, consistant essentiellement en un quantité stoechiométrique de $SnO_2$ et une couche métallique intermédiaire consistant essentiellement en nickel ou en un alliage de nickel ayant au moins 70 % en poids de nickel, dans lequel l'article peut résister à des températures allant de 620°C à 790°C (1150°F à 1450°F), pendant des durées suffisantes pour mélanger et/ou renforcer thermiquement et/ou tremper l'article sans dégradation significative de la couleur, de la durée de vie, de la résistance chimique, de la capacité d'émission, du facteur de réflexion et du facteur de transmission, ces caractéristiques étant définis en terme d'une vitre de véhicule automobile ou architecturale.

**2.** Procédé pour former un article en verre traité thermiquement, comprenant le revêtement sur la surface de l'article en verre, avant le traitement thermique, d'un système de revêtement comprenant une couche supérieure d'oxyde métallique consistant essentiellement en une quantité stoechiométrique de $SnO_2$ et une couche métallique intermédiaire consistant essentiellement en nickel ou à un alliage de nickel ayant au moins 70 % en poids de nickel et, ensuite, exposition de l'article en verre recouvert à un traitement thermique à une température allant d'à peu près 620°C à 790°C (1150°F à 1450°F), pendant des durées suffisantes pour mélanger et/ou renforcer thermiquement et/ou tremper l'article sans dégradation significative de la couleur, de la durée de vie, de la résistance chimique, de la capacité d'émission, du facteur de réflexion et de transmission, ces caractéristiques étant définies en terme d'une vitre de véhicule automobile ou architectural.

**3.** Article selon la revendication 1 ou procédé selon la revendication 2, dans lequel le système d'un revêtement comprend en outre, à titre de couche de revêtement inférieur pour la couche métallique, une couche consistant essentiellement en une quantité stoechiométrique de $SnO_2$.

**4.** Article selon la revendication 1 ou la revendication 3 ou procédé selon la revendication 2 ou la revendication 3, dans lequel le substrat en verre est du verre flotté d'une épaisseur de 2,4 mm à 12,7 mm (3/32 pouce à 1/2 pouce) et le nickel métallique ou la couche d'alliage à teneur élevée en nickel a une épaisseur allant d'à peu près 50 Å à 250 Å, de préférence 150 Å.

**5.** Article selon l'une quelconque des revendications 1, 3 ou 4 ou procédé selon l'une quelconque des revendications 2 à 4, dans lequel la couche de $SnO_2$ a une épaisseur allant d'à peu près quelque Angstroms à à peu près 500 Å, de préférence 160 Å.

**6.** Article selon l'une quelconque des revendications 1 ou 3 à 5 ou procédé selon l'une quelconque des revendications 2 à 5, dans lequel le système de revêtement comprend en outre, à titre de couche intermédiaire, le revêtement supérieur de $SnO_2$ et la couche métallique sélectionnée parmi le nickel ou alliage à teneur élevé en nickel, une deuxième couche métallique consistant essentiellement an aluminium.

**7.** Article selon l'une quelconque des revendications 1 ou 3 à 6, ou procédé selon l'une quelconque des revendications 2 à 6, dans lequel la deuxième couche métallique a une épaisseur allant d'à peu près quelque Angstroms à à peu près 500 Å de préférence 60 Å.

**8.** Article selon l'une quelconque des revendications 1 ou 3 à 7, ou procédé selon l'une quelconque des revendications 2 à 7, dans lequel la couche métallique est un alliage à teneur élevée en nickel constituée de nickel, de chrome et de fer et dans lequel la teneur en nickel ne dépasse pas plus de 90 % en poids.

**9.** Article ou procédé selon la revendication 8, dans lequel l'alliage à teneur élevée en nickel consiste essentiellement en Ni, Fe, Cr, C, Al et Y.

**10.** Article ou procédé selon la revendication 8 ou la revendication 9, dans lequel l'alliage métallique est constitué essentiellement, exprimé en poids, de : 76 % de Ni, 4 % de Fe, 7 % de Cr, moins de 005 % de C, 5 % Al et moins de 0,1 % de Y.

**11.** Article ou procédé selon l'une quelconque des revendications 8 à 10, dans lequel l'alliage à teneur élevé à nickel consiste essentiellement, en poids :

| Elément | % |
|---------|-------|
| Ni | 75,45 |
| Fe | 4,00 |
| Cr | 16,00 |
| C | 0,04 |
| Al | 4,50 |
| Y | 0,01 |

**12.** Procédé selon l'une quelconque des revendications 2 à 11, dans lequel chacune des couches du système de revêtement est formée par un revêtement par pulvérisation.

**13.** Procédé selon la revendication 2, dans lequel le revêtement par pulvérisation a une plus grande valeur magnétiquement.

**14.** Procédé selon la revendication 12 ou la revendication 13, dans lequel la couche de $SnO_2$ est revêtue par pulvérisation dans un environnement contenant de l'oxygène, à l'aide d'une cathode essentiellement en étain pur.

Fig. 1

Fig. 2

Fig. 3